# EUROPEAN PATENT APPLICATION

(11) **EP 2 770 535 A2**
(43) Date of publication of application: **27.08.2014**
(21) Application number: 13183232.1
(22) Date of filing: 05.09.2013
(51) Int. Cl.: H01L 29/40, H01L 29/812, H01L 29/778, H01L 29/20

(54) **Semiconductor device**

(30) Priority: 22.02.2013 JP 2013033752
(71) Applicant: Kabushiki Kaisha Toshiba, Tokyo (JP)
(72) Inventor: Yamamura, Takuji, Tokyo (JP)
(74) Representative: Granleese, Rhian Jane

(57) **Abstract**

A semiconductor device is provided with a semiconductor layer (10), an impurity-doped layer (15) selectively formed on the semiconductor layer, and a drain electrode (30) formed on the impurity-doped layer. The semiconductor device is further provided with a source electrode (20) which is formed and isolated from the drain electrode, and a gate electrode (40) which is formed between the source electrode and the drain electrode. The semiconductor device is provided with an insulating film (17) which is formed between the gate electrode and the drain electrode, and a shielding plate (50) which is formed on the insulating film and is electrically connected to the source electrode. At least a part of the shielding plate is formed above an extending portion of the impurity-doped layer which extends in the direction to the gate electrode from the drain electrode.

## Description

### FIELD

Embodiments relates to semiconductor devices.

### BACKGROUND

There is a semiconductor device which has a structure of a field effect transistor (FET) and has a field plate between a gate electrode and a drain electrode. The field plate relaxes an electric field concentration between a gate and a drain and raises a breakdown voltage, it, however, reduces a career speed just under the gate. For this reason, a radio frequency characteristic of a semiconductor device may be degraded. On the other hand, as for a semiconductor device for a radio frequency, if the field plate is removed, a capacity between the gate and the drain may become large and an oscillation may occur.

### BRIEF DESCRIPTION OF THE DRAWINGS

Fig. 1 is a schematic cross section showing a semiconductor device concerning a first embodiment;
Fig. 2A and Fig. 2B are schematic diagrams showing the semiconductor device concerning the first embodiment;
Fig. 3A is a schematic cross section showing a semiconductor device concerning a modification of the first embodiment;
Fig. 3B is a schematic cross section showing a semiconductor device concerning another modification of the first embodiment;
Fig. 4 is a schematic cross section showing a semiconductor device concerning still another modification of the first embodiment;
Fig. 5A is a schematic cross section showing a semiconductor device concerning a second embodiment;
Fig. 5B and Fig. 5C are schematic cross sections showing semiconductor devices concerning modifications of the second embodiment;
Fig. 6A is a schematic cross section showing a semiconductor device concerning a third embodiment;
Fig. 6B is a schematic cross section showing a semiconductor device concerning a modification of the third embodiment;
Fig. 7A, Fig. 7B, Fig. 7C, and Fig. 7D are schematic cross sections showing a manufacturing process of a semiconductor device concerning a modification of the third embodiment; and
Fig. 8 is a chart which shows a characteristic of a semiconductor device concerning the third embodiment.

### DETAILED DESCRIPTION

Embodiments provide semiconductor devices which are capable of raising a radio frequency characteristic.

A semiconductor device concerning one embodiment is provided with a semiconductor layer, an impurity-doped layer formed on the semiconductor layer, and a drain electrode formed on the impurity-doped layer.

The semiconductor device concerning one embodiment is further provided with a source electrode which is isolated from the drain electrode and formed above the semiconductor layer, and a gate electrode which is formed between the source electrode and the drain electrode and is isolated from the impurity-doped layer. The semiconductor device is further provided with an insulating film formed between the gate electrode and the drain electrode, and a shielding plate which is provide on the insulating film and is electrically connected to the source electrode. The insulating film covers the semiconductor layer and an extending portion of the impurity-doped layer which extends in the direction which faces to the gate electrode from the drain electrode. At least a part of the shielding plate is formed above the extending portion of the impurity-doped layer.

Hereinafter, embodiments are explained referring to the drawings. The same number is given to the same portion in the drawings, an overlapping explanation is omitted suitably, and a different portion is explained.

### [First embodiment]

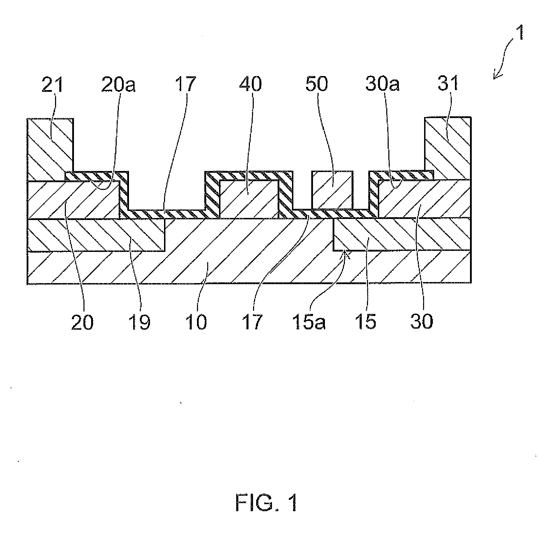

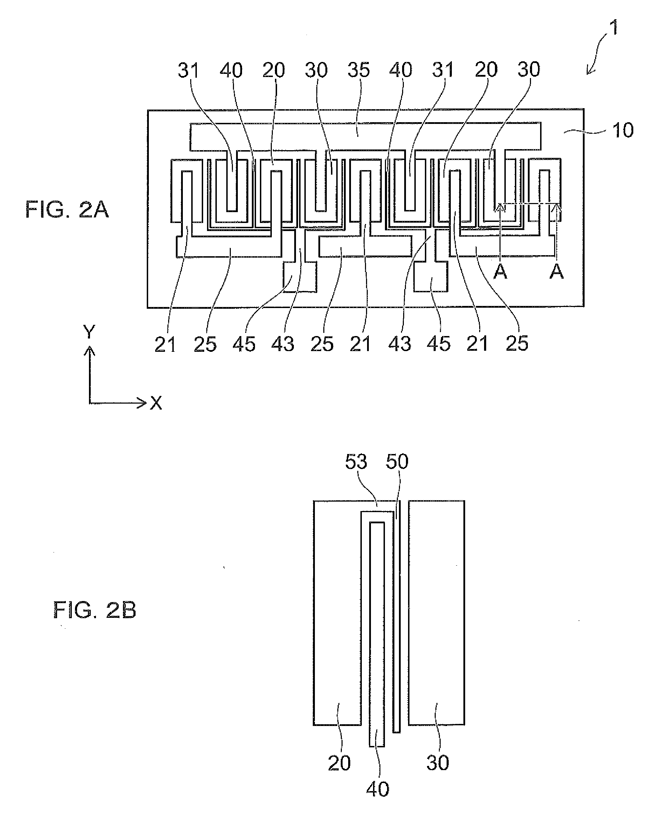

Fig. 1 is a schematic cross section showing a semiconductor device 1 concerning the first embodiment. Fig. 2A shows a chip face of the semiconductor device 1, and Fig. 2B expands and shows a part of the chip face. Fig. 1 shows a cross section taken along an A-A line shown in Fig. 2A.

The semiconductor device 1 is an FET, for example, and is provided with a semiconductor layer 10, a source electrode 20, a drain electrode 30, and a gate electrode 40 formed on the semiconductor layer 10.

As shown in Fig. 1, on the semiconductor layer 10, impurity-doped layers 15 and 19 are formed selectively, respectively. The drain electrode 30 is formed on the impurity-doped layer 15. The source electrode 20 is isolated from the drain electrode 30, and is formed above the semiconductor layer 10. The impurity-doped layer 19 is formed between the source electrode 20 and the semiconductor layer 10.

The gate electrode 40 is isolated from the impurity-doped layers 15 and 19 and formed on the semiconductor layer 10 located between the source electrode 20 and the drain electrode 30. That is, the gate electrode 40 is formed on the semiconductor layer 10 located between the impurity-doped layer 15 and the impurity-doped layer 19.

Further, the semiconductor device 1 is provided with an insulating film 17 which covers the semiconductor layer 10 and the impurity-doped layer 15 located between the gate electrode 40 and the drain electrode 30, and a shielding plate 50 formed on the insulating film 17.

The insulating film 17 further covers the semiconductor layer 10 and the impurity-doped layer 19 located between the gate electrode 40 and the source electrode 20, and the gate electrode 40. In addition, the insulating film 17 extends on a part of an upper surface 20a of the source electrode 20 and a part of an upper surface 30a of the drain electrode 30.

The shielding plate 50 is formed on the insulating film 17. At least a part of the shielding plates 50 is formed above an extending portion 15a of the impurity-doped layer 15 which extends in the direction which faces to the gate electrode 40 from the drain electrode 30.

In the embodiment of Fig. 1, the shielding plate 50 is formed above both the semiconductor layers 10 and the impurity-doped layer 15 which are directly covered with the insulating film 17. The shielding plate 50 is isolated from the drain electrode 30.

As shown in Fig. 2A, the source electrodes 20 and the drain electrodes 30 are formed in a stripe shape which extends in the direction of Y parallel to a surface of the semiconductor layer 10. In addition, the source electrodes 20 and the drain electrodes 30 are arranged in the direction of X, alternately. The gate electrodes 40 extend between the source electrodes 20 and the drain electrodes 30.

Further, the source wiring 21 is formed on the source electrode 20. The source wiring 21 extends in the direction of Y from the source pad 25. The drain wiring 31 is formed on the drain electrode 30. The drain wiring 31 extends in the direction of Y from the drain pad 35. In addition, the gate electrode 40 is connected to the gate pad 45 via the gate wiring 43.

Fig. 2B expands and shows a part of the source electrode 20, a part of the drain electrodes 30, and a part of the gate electrode 40. The gate electrode 40 extends between the source electrode 20 and the drain electrode 30. The shielding plate 50 extends in the direction of Y between the gate electrode 40 and the drain electrode 30. That is, the shielding plate 50 extends along the drain electrode 30. In addition, the shielding plate 50 is electrically connected to the source electrode 20 via a connector 53. Thereby, the gate electrode 40 can be electrically shielded from the drain electrode 30.

The semiconductor layer 10 is an n-type gallium arsenide (GaAs) layer or an n-type gallium nitride (GaN) layer, for example. The n-type GaAs layer is formed on a GaAs substrate of semi-insulation, for example. The n-type GaN layer is formed via a high resistive buffer layer on a silicon substrate, for example. In addition, the n-type GaN layer may be formed on a sapphire substrate, a silicon carbide (SiC) substrate, or an insulating GaN substrate, for example.

The impurity-doped layers 15 and 19 can be formed by, for example, performing an ion implantation of silicon (Si) which serves as an n-type impurity selectively to an n-type GaAs layer and an n-type GaN layer.

An impurity concentration of the impurity-doped layers 15 and 19 is higher than an impurity concentration of the semiconductor layer 10, and is set to equal to or more than 1 x 10¹⁷/cm³, for example. Thereby, a contact resistance between the source electrode 20 and the impurity-doped layer 19 and a contact resistance between the drain electrode 30 and the impurity-doped layer 15 can be reduced.

Further, the impurity-doped layer 15 relaxes an influence which the shielding plate 50 gives on an electric field distribution between a gate and a drain. That is, at least a part of the shielding plate 50 is located above the impurity-doped layer 15 located between the gate electrode 40 and the drain electrode 30. Thereby, a relaxation effect of an electric field concentration between the gate and the drain by the shielding plate 50 can be weakened.

For example, the impurity-doped layer 15 in which silicon is doped by equal to or more than 1x10¹⁷/cm³ is an n+ layer of high electronic concentration, and the impurity-doped layer 15 shields the semiconductor layer 10 from an electric field from the shielding plate 50. And an influence of the shielding plate 50 on distribution of electric flux lines in the semiconductor layer 10 is reduced, and a fall of field intensity in the semiconductor layer 10 just under the gate electrode 40 is restrained, for example. Thereby, a radio frequency characteristic of the semiconductor device 1 can be improved.

Thus, in this embodiment, by forming the shielding plate 50 between the gate electrode 40 and the drain electrode 30, the gate electrode 40 is electrically shielded from the drain electrode 30, and a parasitic capacitance Cgd between the gate and the drain is reduced. Furthermore, the radio frequency characteristic can be improved by forming at least a part of the shielding plate 50 above the impurity doped layer 15.

### [Modifications of the first embodiment]

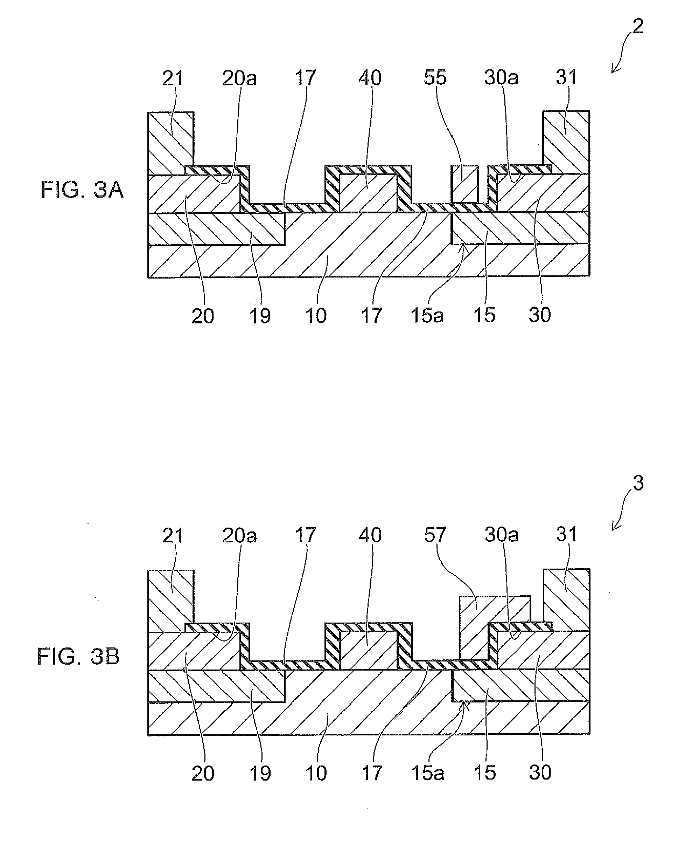

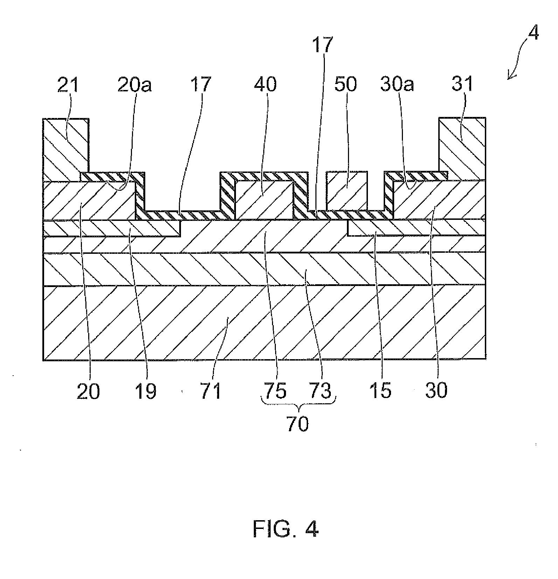

Next, with reference to Fig. 3A, Fig. 3B, and Fig. 4, the semiconductor devices 2, 3 and 4 concerning the modifications of this embodiment are explained. Fig. 3A and Fig. 3B are schematic cross sections showing the semiconductor devices 2 and 3 concerning modifications of the first embodiment, respectively. Fig. 4 is a schematic cross section showing the semiconductor device 4 concerning another modification of the first embodiment.

The semiconductor device 2 shown in Fig. 3A is provided with a semiconductor layer 10, a impurity-doped layers 15 and 19 selectively formed on the semiconductor layer 10, a source electrode 20, a drain electrode 30, and a gate electrode 40. The source electrode 20 and the drain electrode 30 are formed on the impurity-doped layers 19 and 15, respectively. The gate electrode 40 is formed on the semiconductor layer 10 located between the impurity-doped layer 15 and the impurity-doped layer 19.

The semiconductor device 2 is provided with an insulating film 17 which covers the semiconductor layer 10 and the impurity-doped layer 15 located between the gate electrode 40 and the drain electrode 30, and a shielding plate 55 formed on the insulating film 17. And the shielding plate 55 is formed above the impurity-doped layer 15 which extends in the direction which faces to a gate electrode from the drain electrode 30.

That is, in this modification, the shielding plate 55 is formed above the impurity-doped layer 15, and does not extend above a portion of the semiconductor layer 10 which the insulating film 17 covers directly. Thereby, the impurity-doped layer 15 can relax more an influence of the shielding plate 55 on an electric field distribution in the semiconductor layer 10. Accordingly, a fall of field intensity under the gate electrode 40 can be restrained further.

As for the semiconductor device 3 shown in Fig. 3B, a shielding plate 57 is formed above an impurity-doped layer 15 which extends in the direction which faces to a gate electrode 40 from a drain electrode 30, and the shielding plate 57 extends above the drain electrode 30. That is, the shielding plate 57 covers a part of an upper surface 30a of the drain electrode 30 via the insulating film 17. Thereby, the shielding plate 57 blocks more electric flux lines between a gate and a drain, and reduces a parasitic capacitance Cgd between the gate and the drain further.

A semiconductor device 4 shown in Fig. 4 is provided with a semiconductor layer 70, a source electrode 20 and a drain electrode 30 which are formed above the semiconductor layer 70, and a gate electrode 40 which is formed on the semiconductor layer 70.

The semiconductor layer 70 is formed on an high resistive layer 71, for example. The semiconductor layer 70 includes a channel layer 73 and a barrier layer 75. The channel layer 73 is a GaAs layer and the barrier layer 75 is an AlGaAs layer which is doped with n-type impurities, for example. As another example, a GaN layer may be used as the channel layer 73, and an AlGaN layer may be used also as the barrier layer 75.

On the barrier layer 75, impurity-doped layers 15 and 19 are formed selectively, respectively. And then, the source electrode 20 and the drain electrode 30 are formed on the impurity-doped layers 19 and 15, respectively. The gate electrode 40 is formed on the barrier layer 75 located between the impurity-doped layer 15 and the impurity-doped layer 19.

A shielding plate 50 is formed on an insulating film 17. At least a part of the shielding plate 50 is formed above an extending portion of the impurity-doped layer 15 which extends in the direction which faces to the gate electrode 40 from the drain electrode 30. In an example of Fig. 4, the shielding plate 50 is formed above the barrier layer 75 and the impurity-doped layer 15 via the insulating film 17 located between the gate electrode 40 and the drain electrode 30.

In the semiconductor device 4, two-dimensional electron gas is induced at an interface between the channel layer 73 and the barrier layer 75, and a drain current flows between the source electrode 20 and the drain electrode 30. And the drain current is controlled by a gate bias applied to the gate electrode 40 which forms a schottky contact with the barrier layer 75.

The shielding plate 50 of this modification also shields the gate electrode 40 electrically from the drain electrode 30, and reduces a parasitic capacitance Cgd between a gate and a drain. By forming at least a part of the shielding plate 50 above the impurity-doped layer 15, the impurity-doped layer 15 can restrain a fall of field intensity just under the gate electrode 40 and can improve a radio frequency characteristic.

### [Second embodiment and modifications thereof]

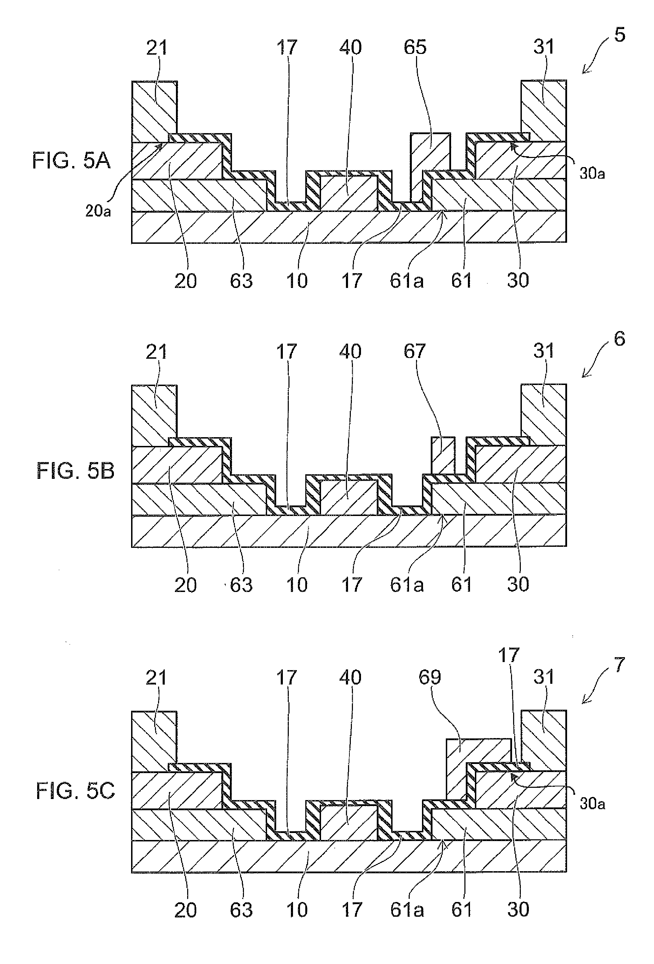

Fig. 5A is a schematic cross section showing a semiconductor device 5 concerning the second embodiment. Fig. 5B and Fig. 5C are schematic cross sections showing semiconductor devices 6 and 7 concerning modifications of the second embodiment.

Each of the semiconductor devices 5-7 is provided with a semiconductor layer 10 and impurity-doped layers 61 and 63 selectively formed on the semiconductor layer 10. The impurity-doped layers 61 and 63 can be formed by, for example, etching selectively an epitaxial layer grown-up on the semiconductor layer 10. The impurity-doped layers 61 and 63 are n+ layers in which an n-type impurity was doped at higher concentration than the semiconductor layer 10, for example. An n-type impurity concentration of the impurity-doped layers 61 and 63 is equal to or more than 1x10¹⁷/cm³, for example.

A source electrode 20 and a drain electrode 30 are formed on the impurity-doped layers 63 and 61, respectively. A gate electrode 40 is formed on the semiconductor layer 10 exposed between the impurity-doped layer 61 and the impurity-doped layer 63.

Further, there is formed an insulating film 17 which covers the gate electrode 40, the semiconductor layer 10 exposed between the impurity-doped layer 61 and the impurity-doped layer 63, a part of the impurity-doped layer 61 which extends in the direction which faces to the gate electrode 40 from the drain electrode 30, and a part of the impurity-doped layer 63 which extends in the direction which faces to the gate electrode 40 from the source electrode 20. The insulating film 17 covers a part of the drain electrode 30, and extends on an upper surface 30a of the drain electrode 30. And the insulating film 17 covers a part of the source electrode 20, and extends on an upper surface 20a of the source electrode 20.

The semiconductor device 5 shown in Fig. 5A is provided with a shielding plate 65 formed on the insulating film 17 located between the drain electrode 30 and the gate electrode 40. The shielding plate 65 is formed so as to straddle an extending portion 61 a of the impurity-doped layer 61 which extends in the direction which faces to the gate electrode 40 from the drain electrode 30 and the semiconductor layer 10 exposed between the impurity-doped layer 61 and the impurity-doped layer 63.

The semiconductor device 6 shown in Fig. 5B is provided with a shielding plate 67 formed on the insulating film 17 located between the drain electrode 30 and the gate electrode 40. The shielding plate 67 is formed above an extending portion 61 a of the impurity-doped layer 61 which extends in the direction which faces to the gate electrode 40 from the drain electrode 30.

The semiconductor device 7 shown in Fig. 5C is provided with a shielding plate 69 formed on the insulating film 17 located between the drain electrode 30 and the gate electrode 40. The shielding plate 69 is formed above an extending portion 61 a of the impurity-doped layer 61 which extends in the direction which faces to the gate electrode 40 from the drain electrode 30. In addition, the shielding plate 69 extends above the drain electrode 30 along the insulating film 17, and covers a part of an upper surface 30a of the drain electrode 30.

According to this embodiment and modifications thereof, the impurity-doped layers 61 and 63 are formed by epitaxial growth methods, such as an MOCVD (Metal Organic Chemical Vapor Deposition) method. And the impurity-doped layers 61 and 63 reduce contact resistance of the drain electrode 30 and the source electrode 20, respectively.

Furthermore, the impurity-doped layer 61 reduces an influence of the shielding plate 65 given to an electric field distribution in the semiconductor layer 10, and restrains a fall of field intensity just under the gate electrode 40. Thereby, a radio frequency characteristic of the semiconductor device 5 is improved.

In the semiconductor device 6 shown in Fig. 5B, the shielding plate 67 is formed above the extending portion 61a of the impurity-doped layer 61 which extends in the direction which faces to the gate electrode 40 from the drain electrode 30, and is not formed above the semiconductor layer 10 exposed between the gate electrode 40 and the drain electrode 30. For this reason, a fall of field intensity just under the gate electrode 40 can be restrained further, and a radio frequency characteristic of the semiconductor device 6 can be improved.

In the semiconductor device 7 shown in Fig. 5C, since the shielding plate 69 extends above the upper surface 30a of the drain electrode 30, an effect which shields the gate electrode 40 from the drain electrode 30 is increased, and a parasitic capacitance Cgd between a gate and a drain is reduced further.

### [Third embodiment]

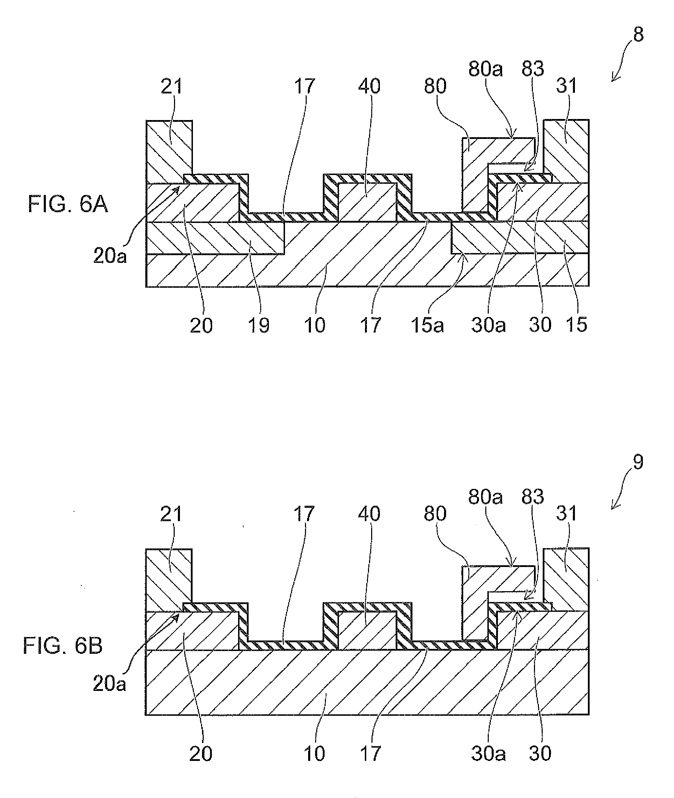

Fig. 6 is a schematic cross section showing a semiconductor device concerning the third embodiment.

The semiconductor device 8 shown in Fig. 6A is provided with a semiconductor layer 10, impurity-doped layers 15 and 19 selectively formed on the semiconductor layer 10, a source electrode 20, a drain electrode 30, and a gate electrode 40. The source electrode 20 and the drain electrode 30 are formed on the impurity-doped layers 19 and 15, respectively. The gate electrode 40 is formed on the semiconductor layer 10 located between the impurity-doped layer 15 and the impurity-doped layer 19.

The semiconductor device 8 is further provided with an insulating film 17 which covers the semiconductor layer 10 located between the gate electrode 40 and the drain electrode 30, and an extending portion 15a of the impurity-doped layer 15 which extends in the direction which faces to the gate electrode 40 from the drain electrode 30.
The insulating film 17 covers the gate electrode 40, the semiconductor layer 10 located between the gate electrode 40 and the source electrode 20, and a part of the impurity-doped layer 19 which extends in the direction which faces to the gate electrode 40 from the source electrode 20. In addition, the insulating film 17 covers a part of the source electrode 20 and a part of the drain electrode 30, and extends on an upper surface 20a of the source electrode 20 and an upper surface 30a of the drain electrode 30.

A shielding plate 80 is formed on the insulating film 17. The shielding plate 80 is formed above the extending portion 15a of the impurity-doped layer 15, and extends above the drain electrode 30. An extending portion 80a of the shielding plate 80 which extends above the drain electrode 30 faces the upper surface 30a of the drain electrode 30 via an air gap 83 and the insulating film 17.

According to this embodiment shown in Fig. 6A, the shielding plate 80 has the extending portion 80a which extends above the upper surface 30a of the drain electrode 30, and the air gap 83 is formed between the extending portion 80a and the drain electrode 30. Thereby, a parasitic capacitance Cds between the source electrode 20 electrically connected with the shielding plate 80 and the drain electrode 30 can be reduced, and a gain of the semiconductor device 8 can be increased.

On the other hand, the extending portion 15a of the impurity-doped layer 15 restrains a fall of field intensity just under the gate electrode 40 caused by the shielding plate 80. And the shielding plate 80 reduces a parasitic capacitance Cgd between the gate electrode 40 and the drain electrode 30. As a result, the shielding plate 80 formed above the extending portion 15a improves a radio frequency characteristic of the semiconductor device 8.

### [Modification of third embodiment]

Fig. 6B is a schematic cross section showing a semiconductor device 9 concerning a modification of the third embodiment. The semiconductor device 9 shown in Fig. 6B is provided with a semiconductor layer 10, and a source electrode 20, a drain electrode 30 and a gate electrode 40 which are formed on the semiconductor layer 10. The semiconductor device 9 is further provided with an insulating film 17 which covers the semiconductor layer 10 located between the gate electrode 40 and the drain electrode 30. The insulating film 17 covers the gate electrode 40 and the semiconductor layer 10 located between the gate electrode 40 and the source electrode 20. In addition, the insulating film 17 covers a part of the source electrode 20 and a part of the drain electrode 30, and extends to an upper surface 20a of source electrode 20 and an upper surface 30a of drain electrode 30.

A shielding plate 80 is formed on the insulating film 17. The shielding plate 80 extends above the drain electrode 30 from above the semiconductor layer 10. An extending portion 80a of the shielding plate 80 which extends above the drain electrode 30 faces the upper surface 30a of the drain electrode 30 via an air gap 83 and the insulating film 17.

In the modification of the third embodiment shown in Fig. 6B, the shielding plate 80 has the extending portion 80a which extends above the upper surface 30a of the drain electrode 30, and the air gap 83 is formed between the extending portion 80a and the drain electrode 30. Accordingly, a parasitic capacitance Cds between the source electrode 20 electrically connected with the shielding plate 80 and the drain electrode 30 can be reduced, and a gain of the semiconductor device 9 can be enlarged, for example.

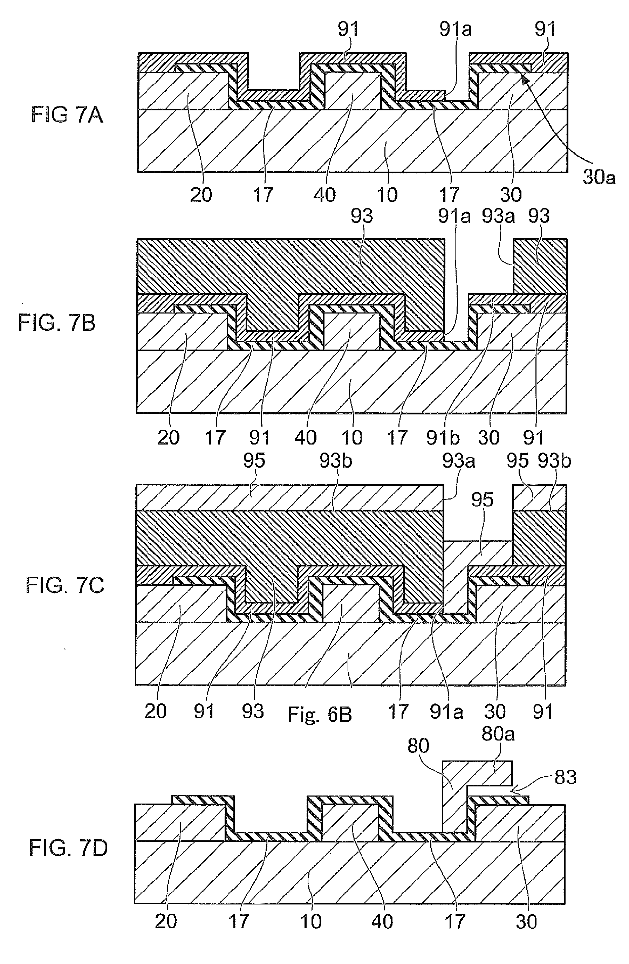

Fig. 7A to Fig. 7D are schematic cross sections showing a manufacturing process of the semiconductor device 9 of Fig. 6B. A formation process of the shielding plate 80 which has the air gap 83 is shown.

For example, as shown in Fig. 7A, a first resist layer (hereinafter, it is called a resist layer 91) is formed above the semiconductor layer 10 on which the source electrode 20, the drain electrode 30, the gate electrode 40 and the insulating film 17 has been formed. Between the gate electrode 40 and the drain electrode 30, the resist layer 91 has an opening 91a which reaches the insulating film 17. The resist layer 91 is cured by heat treatment of not less than 100 degrees C, for example.

Next, as shown in Fig. 7B, a second resist layer (hereinafter, it is called a resist layer 93) is formed on the resist layer 91. The resist layer 93 has an opening 93a. Between the gate electrode 40 and the drain electrode 30, the opening 93a is connected with the opening 91 a of the resist layer 91, and reaches the insulating film 17. Further, the opening 93a spreads over the upper surface 30a of the drain electrode 30, and exposes a part 91 b of the resist layer 91.

Next, as shown in Fig. 7C, there is formed a metal layer 95 which covers an upper surface 93b of the resist layer 93, bottoms of the opening 91 a and the opening 93a. The metal layer 95 is formed using a vacuum evaporation method, for example.

Next, as shown in Fig. 7D, the metal layer 95 formed on the resist layer 93 is removed by stripping the resist layers 91 and 93 using wet processing, for example. Thereby, there is formed the shielding plate 80 which is in contact with the insulating film 17 between the gate electrode 40 and the drain electrode 30. A part of the shielding plate 80 extends above the drain electrode 30. Between the extending portion 80a of the shielding plate 80 and the insulating film 17, the air gap 83 is formed by removing the resist layer 91. Then, a source wiring 21, a drain wiring 31 etc. are formed, and the semiconductor device 9 is completed. Also regarding the semiconductor device of Fig. 6A, the shielding plate 80 which has the air gap 83 can be formed by the manufacturing process shown in Fig. 7A to Fig. 7D. That is, the air gap 83 is formed between the shielding plate 80 and the insulating layer 17 on the drain electrode 30.

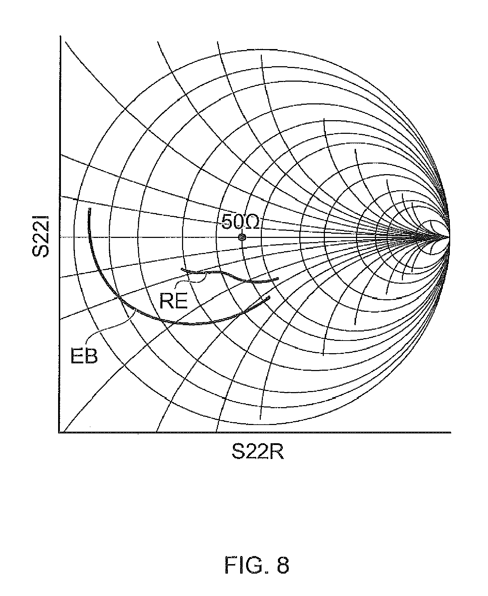

Fig. 8 is a chart which shows a characteristic of the semiconductor device of Fig. 6B. A curve EB is a reflection loss S22 of an output side of the semiconductor device 9. A curve RE is a reflection loss S22 of a semiconductor device without the shielding plate 80.

Both the curves EB and RE show capacitive reflection losses. A capacity ingredient of the curve EB is larger than a capacity ingredient of the curve RE. For this reason, for example, when the output side is connected to an output circuit via a metal wire, an impedance match of the semiconductor device 9 which has the characteristic of the curve EB can be performed more easily than an impedance match of a semiconductor device which has the characteristic of the curve RE. That is, an impedance match between the output side and the output circuit can be easily performed by forming the shielding plate 80 between the gate electrode 40 and the drain electrode 30.

As mentioned above, although the first embodiment - the third embodiment were illustrated and explained, the embodiments are not restricted to these. For example, although above-mentioned FET has a schottky gate, insulating gates, such as MOS (Metal Oxide Semiconductor) structure, may be used.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions.

## Claims

1. A semiconductor device, comprising
a semiconductor layer;
an impurity-doped layer which is formed on the semiconductor layer;
a drain electrode which is formed on the impurity-doped layer;
a source electrode which is isolated from the drain electrode and is formed above the semiconductor layer;
a gate electrode which is formed between the source electrode and the drain electrode and is isolated from the impurity-doped layer;
an insulating film which is formed between the gate electrode and the drain electrode, and which covers the semiconductor layer and an extending portion of the impurity-doped layer which extends in the direction which faces to the gate electrode from the drain electrode; and
a shielding plate which is formed on the insulating film and is electrically connected to the source electrode, wherein at least a part of the shielding plate is formed above the extending portion of the impurity-doped layer.

2. The semiconductor device according to the claim 1, further comprises another impurity-doped layer formed between the semiconductor layer and the source electrode.

3. The semiconductor device according to the claim 1, wherein the shielding plate is formed above the impurity-doped layer.

4. The semiconductor device according to the claim 1, wherein the shielding plate is isolated from the drain electrode.

5. The semiconductor device according to the claim 1, wherein the shielding plate extends above the drain electrode and faces an upper surface of the drain electrode via an air gap.

6. The semiconductor device according to the claim 1, wherein the insulating film extends on the drain electrode, and the shielding plate covers the upper surface of the drain electrode via the insulating film.
